# EUROPÄISCHE PATENTSCHRIFT

(11) **EP 0 910 234 B1**
(45) Veröffentlichungstag und Bekanntmachung des Hinweises auf die Patenterteilung: **05.01.2005**
(21) Anmeldenummer: 98109604.3
(22) Anmeldetag: 27.05.1998
(51) Int. Cl.: H05K 7/14, H05K 5/02

(54) **Funktionsbaugruppe mit Hinweisschild bei einer speicherprogrammierbaren Steuerung**
Function module with indicator for automation apparatus
Module fonctionnel d'un automate programmable avec panneau indicateur

(30) Priorität: 14.10.1997 DE 29718106 U
(43) Veröffentlichungstag der Anmeldung: 21.04.1999
(73) Patentinhaber: VIPA Gesellschaft für Visualisierung und Prozessautomatisierung m.b.H., 91074 Herzogenaurach (DE)
(72) Erfinder: Seel, Wolfgang, 90419 Nürnberg (DE)
(74) Vertreter: Dreykorn-Lindner, Werner, Dipl.-Ing.

(56) Entgegenhaltungen:
- EP-A- 0 673 108
- DE-A- 4 413 647
- DE-U- 8 802 659
- GB-A- 2 223 884

## Beschreibung

Die Erfindung betrifft eine Funktionsbaugruppe mit Hinweisschild bei einer speicherprogrammierbaren Steuerung (Patentanspruch 1).

Hinweisschilder in unterschiedlicher Ausgestaltung als Zubehörteil oder als Teil des elektrischen Geräts oder Systems sind bekannt. Beispielsweise ist aus der DE 40 11 728 A1 eine Meldezentrale bekannt, bei der zum modularen Aufbau des Chassis u.a. eine Leiterplatte als Basis-Platine mit Steckverbindern zur Aufnahme von Funktionsbaugruppen, sowie ein Gehäuseoberteil mit Beschriftungseinlage und Abdeckplatte vorgesehen ist.

Weiterhin ist aus der DE 40 13 803 A1 ein zweiteiliger Abdeckrahmen mit Beschriftungsschild für elektrische Unterputzinstallationsgeräte bekannt, bei dem auf das Rahmenunterteil ein gleichformatiges, transparentes Rahmenoberteil aufrastbar ist. Eine Traverse des verrasteten Abdeckrahmens bildet einen zum Rahmeninneren hin geöffneten Schlitz, in dem ein Beschriftungsschild einschiebbar ist. In ähnlicher Weise ist eine Kommunikationssteckdose mit Adapter für den Gebrauch mit beliebigen Abdeckprogrammen von Hausinstallationsgeräten gemäß der DE 43 11 137 A1 ausgestaltet, bei der u.a. zur Kennzeichnung der Kommunikationssteckdose Beschriftungsleisten vorgesehen sind, die mittels Rastnasen in dafür am Anpassteil vorgesehenen Aussparungen verrastend eingreifen.

Schließlich ist aus dem DE 94 04 276 U1 ein Baugruppenträger zur Aufnahme von Steckbaugruppen, die von vorne einschiebbar sind, bekannt. Der Baugruppenträger ist mit einer Beschriftungsschiene versehen, die um eine im wesentlichen parallel zu einer Kante des Baugruppenträgers verlaufende Achse schwenkbar gelagert und derart ausgebildet ist, dass sie sich in einer ersten Endlage vor den Steckbaugruppen innerhalb der Baugruppenträger-Frontfläche und in einer zweiten Endlage ausserhalb der Baugruppenträger-Frontfläche befindet.

Wie die vorstehende Würdigung des Standes der Technik aufzeigt, sind unterschiedliche Ausführungsformen für verschiedene Anwendungsfälle bekannt. Im praktischen Gebrauch über einen längeren Zeitraum hinaus stellt sich als nachteilig heraus, dass auf diesen Schildern kein Platz für einen ausführlichen Hinweis vorhanden ist.

Der Erfindung liegt gegenüber dem beschriebenen Stand der Technik die Aufgabe zugrunde, eine Funktionsbaugruppe, welche ein Hinweisschild anfweist, derart auszugestalten, dass Platz für einen ausführlichen Hinweis vorhanden ist und dass zum Sichtbarmachen dieses Hinweises nur einfache Handgriffe erforderlich sind.

Diese Aufgabe wird von einer Funktionsbaugruppe mit Hinweisschild bei einer speicherprogrammierbaren Steuerung, wobei die Steuerung einen Baugruppenträger zur Aufnahme der Funktionsbaugruppen aufweist, gelöst, indem deren jeweiliges Gehäuse an einer Seitenfläche zwei im Abstand zueinander parallel verlaufende Führungselemente, welche das Hinweisschild teilweise umgreifen, und ein Anschlagteil für die Auszugs-Begrenzung des linear verschiebbaren Hinweisschilds aufweisen.

Die erfindungsgemäße Baugruppe weist den Vorteil auf, dass auf überraschend einfache Art und Weise die Beschriftungsfläche vergrößert werden kann, ohne daß hiermit eine umständliche oder schwierige Handhabung für den Benutzer verbunden ist.

Der Erfindung liegt die Erkenntnis zugrunde, dass vor allen Dingen im Störungsfall bei einer speicherprogrammierbaren Steuerung und der damit verbundenen Komplexität des Systems, dem Servicetechniker ein gezielter Hinweis auf den Störungscode (z.B. E 0.6, bedeutet: Hydraulik aus) gegeben werden muß.

Bei einer bevorzugten Ausgestaltung der Erfindung gemäß Patentanspruch 2, ist das Gehäuse zweiteilig ausgestaltet; im ersten Gehäuseteil sind die Führungselemente auf der Innenseite angeordnet und das zweite Gehäuseteil weist entweder zwei hierzu korrespondierende Führungselemente auf der Außenseite oder frontseitig einen Schlitz auf.

Bei dieser Ausgestaltung ist eine sichere Führung des Hinweisschildes gewährleistet, obwohl ein zweiteiliges Gehäuse benutzt wird. Das Hinweisschild selbst weist vorzugsweise eine ausreichende Steifigkeit auf, so dass auch beim Sichtbarmachen des vollständigen Hinweisschildes in der Praxis keine Probleme auftreten.

In Weiterbildung der Erfindung nach Patentanspruch 3, ist das Hinweisschild blattförmig mit einem Reiter ausgestaltet und weist eine Aussparung auf.

Diese Weiterbildung weist den Vorteil auf, daß eine einfache Handhabung zum Verschieben des Hinweisschildes mittels Reiter gegeben ist. Zudem ist mittels der Aussparung die Möglichkeit gegeben, ein unbeabsichtigtes Herausziehen des gesamten Hinweisschildes zu verhindern.

Gemäß Patentanspruch 4 ist in Weiterbildung der Erfindung das Anschlagteil für die Auszugs-Begrenzung auf der Innenseite und im Randbereich des ersten Gehäuseteils angeordnet und ist keilförmig ausgestaltet.

Mit dieser Weiterbildung der Erfindung ist neben dem Schutz gegen unbeabsichtigtes Herausziehen auch eine einfache Möglichkeit gegeben, beispielsweise mittels eines Schraubendrehers oder mittels einer weiteren zwischen Keil und Hinweisschild eingeschobenen steifen Karte, das Hinweisschild vollständig herauszuziehen.

In Weiterbildung der Erfindung nach Patentanspruch 5, weist das Gehäuse frontseitig eine transparente Abdeckplatte auf, deren Längsseite parallel und nahe zum Hinweisschild verläuft.

Diese Weiterbildung weist den Vorteil auf, daß im Betrieb der speicherprogrammierbaren Steuerung durch optische Signalmittel, z.B. rote/grüne LED's, der Betriebszustand an der entsprechenden Zeile des Hinweisschildes angezeigt wird.

Bei einer Ausgestaltung der Erfindung gemäß Patentanspruch 6, weist das zweite Gehäuseteil im Frontbereich eine Nut für das Einstecken eines Beschriftungsschildes auf.

Bei dieser Ausgestaltung wird ein zusätzlicher Platz für eine ergänzende Bezeichnung z.B. der Funktionsbaugruppe selbst geschaffen.

Schließlich springt bei einer Ausgestaltung der Erfindung gemäß Patentanspruch 7, der Mantel des zweiten Gehäuseteils zwischen den beiden Führungselementen zurück und diese sind als Lappen ausgestaltet. Eine solche Führung weist den Vorteil der kostengünstigen Herstellung auf.

Weitere Vorteile und Einzelheiten lassen sich der nachfolgenden Beschreibung einer bevorzugten Ausführungsform der Erfindung unter Bezugnahme auf die Zeichnung entnehmen. In der Zeichnung zeigt:
- FIG. 1: eine Schrägansicht auf die erfindungsgemäß ausgestalteten Funktionsbaugruppen einer speicherprogrammierbaren Steuerung,
- FIG. 2: eine Draufsicht auf ein Hinweisschild gemäß der Erfindung,
- FIG. 3: eine Schrägansicht auf das zweiteilige Gehäuse der erfindungsgemäß ausgestalteten Funktionsbaugruppen im geöffneten Zustand,
- FIG. 4: eine Draufsicht auf die Unterseite des zweiten Gehäuseteils gemäß der Erfindung und
- FIG. 5: das zweite Gehäuseteil mit Längsmittelschnitt in der Ebene A-A in Fig. 4.

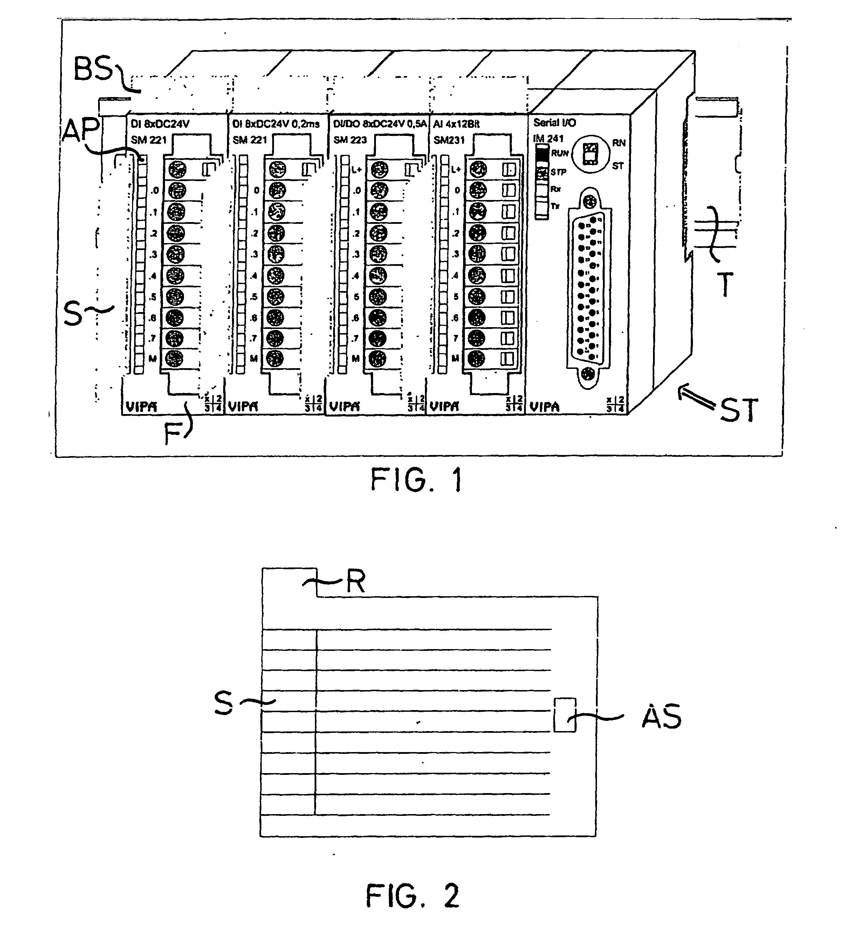

Die FIG. 1 zeigt eine Schrägansicht auf die erfindungsgemäß ausgestalteten Funktionsbaugruppen F einer speicherprogrammierbaren Steuerung ST, wobei die Funktionsbaugruppe F ein Hinweisschild S aufweist. Die speicherprogrammierbare Steuerung ST besteht in der Regel aus gleichgroßen quaderförmigen Funktionsbaugruppen F, wobei an der Rückwand Befestigungsmittel, z.B. in Form einer aus biegsamen Material (auch Plastik) bestehenden Feder mit V-förmigen Stegen, zum Halten in einem Baugruppenträger T vorgesehen sind. Der Baugruppenträger T besteht aus Stangen und Winkelstücken, welche durch Schraubmittel zusammengehalten werden und welcher auch Anschlußmittel für einen Bus aufweist.
FIG. 2 zeigt in Draufsicht eine Ausführungsform für das Hinweisschild S. Im einzelnen ist das Hinweisschild S blattförmig mit einem Reiter ausgestaltet und weist eine Aussparung AS auf. Für einen guten Kontrast bei der Störungsanzeige kann vorzugsweise weißer Papierkarton, weißes Plastikmaterial ö.ä benutzt werden, wobei der Klartext der einzelnen Beschriftungszeile aufgedruckt ist und in der ersten Spalte der Störungscode und in der zweiten Spalte schlagwortartig der Störungsort steht.

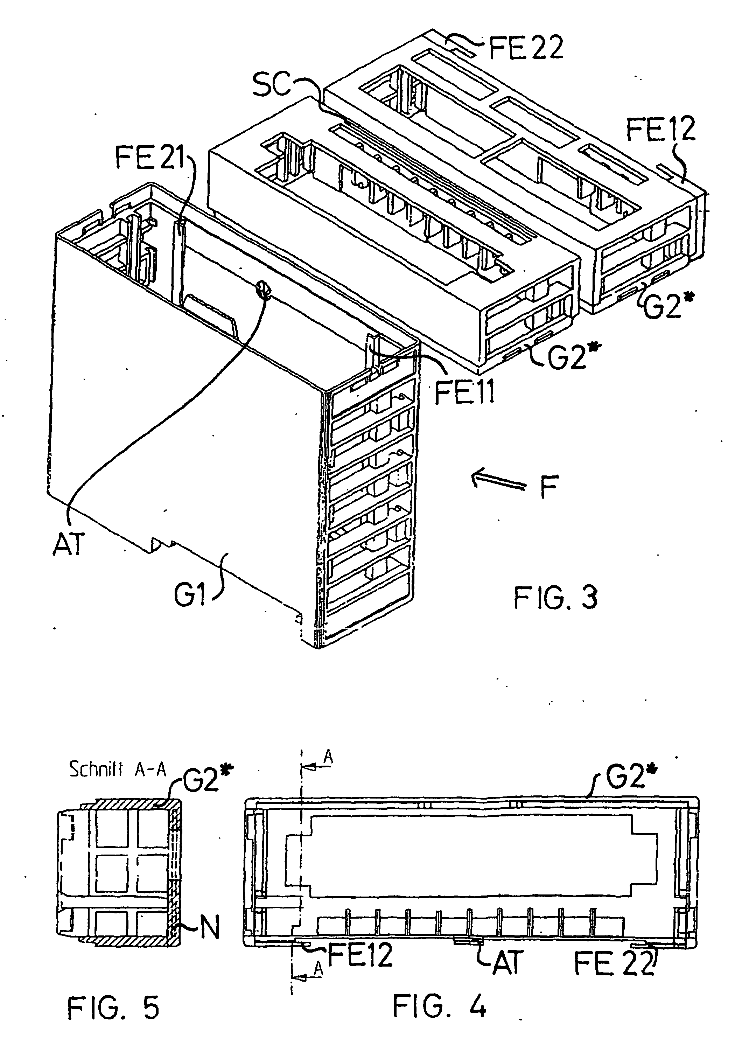

Die Führung des blattförmigen Hinweisschildes S ist in FIG. 3 und in FIG. 4 dargestellt. Im ersten Gehäuseteil G1 sind die Führungselemente FE11, FE21 auf der Innenseite angeordnet. Das zweite Gehäuseteil weist entweder zwei hierzu korrespondierende Führungselemente FE12, FE22 auf der Außenseite oder frontseitig einen Schlitz SC auf. Das Anschlagteil AT für die Auszugs-Begrenzung ist auf der Innenseite und im Randbereich des ersten Gehäuseteils G1 angeordnet und ist vorzugsweise keilförmig ausgestaltet.

Schließlich zeigt FIG. 5 auf, wie ein zusätzlicher Platz für eine ergänzende Bezeichnung, z.B. der Funktionsbaugruppe selbst, geschaffen wird, indem im Frontbereich des zweiten Gehäuseteils G2* eine Einstecköffnung, beispielsweise eine Nut N oder ein Sackloch, für das Einstecken eines Beschriftungsschildes BS vorgesehen wird.

Die Erfindung ist nicht auf das dargestellte Ausführungsbeispiel beschränkt. Es ist beispielsweise im Rahmen der Erfindung denkbar, die Führungselemente auf dem Mantel eines einteiligen Gehäuses anzuordnen, anstelle einer durchgängigen Schiene im Abstand zueinander entsprechende Lappen am Gehäuse herauszuformen u.a. Alle dargestellten und beschriebenen Ausführungsmöglichkeiten, sowie ihre Kombination untereinander, sind erfindungswesentlich.

## Patentansprüche

1. Funktionsbaugruppe (F) mit Hinweisschild (S) bei einer speicherprogrammierbaren Steuerung (ST), wobei die Steuerung (ST) einen Baugruppenträger (T) zur Aufnahme der Funktionsbaugruppen (F) aufweist, deren jeweiliges Gehäuse (G1, G2*) an einer Seitenfläche zwei im Abstand zueinander parallel verlaufende Führungselemente (FE11, FE21 bzw. FE12, FE22), welche das Hinweisschild (S) teilweise umgreifen, und ein Anschlagteil (AT) für die Auszugs-Begrenzung des linear verschiebbaren Hinweisschilds (S) aufweist.

2. Funktionsbaugruppe nach Anspruch 1, **dadurch gekennzeichnet, dass** das Gehäuse (G1, G2*) zweiteilig ausgestaltet ist, dass im ersten Gehäuseteil (G1) die Führungselemente (FE11, FE21) auf der Innenseite angeordnet sind und dass das zweite Gehäuseteil (G2*) entweder zwei hierzu korrespondierende Führungselemente (FE12, FE22) auf der Außenseite oder frontseitig einen Schlitz (SC) aufweist.

3. Funktionsbaugruppe nach Anspruch 1, **dadurch gekennzeichnet, dass** das Hinweisschild (S) blattförmig mit einem Reiter (R) ausgestaltet ist und eine Aussparung (AS) aufweist.

4. Funktionsbaugruppe nach Anspruch 2, **dadurch gekennzeichnet, dass** das Anschlagteil (AT) für die Auszugs-Begrenzung auf der Innenseite und im Randbereich des ersten Gehäuseteils (G1) angeordnet und keilförmig ausgestaltet ist.

5. Funktionsbaugruppe nach einem oder mehreren der Ansprüche 1 bis 4, **dadurch gekennzeichnet, dass** das Gehäuse (G2*) frontseitig eine transparente Abdeckplatte (AP) aufweist, deren Längsseite parallel und nahe zum Hinweisschild (S) verläuft.

6. Funktionsbaugruppe nach einem oder mehreren der Ansprüche 1 bis 5, **dadurch gekennzeichnet, dass** das zweite Gehäuseteil (G2*) im Frontbereich eine Nut (N) für das Einstecken eines Beschriftungsschildes (BS) aufweist.

7. Funktionsbaugruppe nach Anspruch 2, **dadurch gekennzeichnet, dass** der Mantel des zweiten Gehäuseteils (G2*) zwischen den beiden Führungselementen (FE12, FE22) zurückspringt und diese als Lappen ausgestaltet sind.

## Claims

1. A functional module (F) with indicator sheet (S) for application in a programmable logic controller (ST), **characterised in that** said controller (ST) comprises a rack (T) for the insertion of functional modules (F), the module bodies of which (G1, G2*) provide two parallel guide members on a lateral surface (FE11, FE21 respectively FE12, FE22), wherein said guide members partially enclose the indicator sheet (S), and a backstop (AT) for the pull-out of the linearly movable indicator sheet (S).

2. Module according to claim 1, **characterised in that** said module body (G1, G2*) consists of two parts and wherein the first body member (G1) has guide members (FE11, FE21) arranged on the inside and wherein the second body member (G2*) has either two corresponding guide members (FE12, FE22) on the outside or provides a slot (SC) on the front side.

3. The functional module according to claim 1, **characterised in that** said indicator sheet (S) is formed like a sheet with a rider (R) and includes an empty space (AS).

4. Module according to claim 2, **characterised in that** said backstop (AT) for the pull-out is arranged on the inside and in the peripheral area of the first body member (G1) and is formed in a wedge-shape.

5. Module according to any one of claims 1 to 4, **characterised in that** said body member (G2*) provides a transparent front cover plate (AP), the longitudinal side of which runs parallel and close to the indicator sheet (S).

6. Module according to any one of claims 1 to 5, **characterised in that** said second body member (G2*) provides a notch (N) in the front area for the insertion of a lettering label (BS).

7. Module according to claim 2, **characterised in that** said jacket of the second, body member (G2*) jumps back between both guide members' (FE12, FE22) and those are formed as rags.

## Revendications

1. Groupe fonctionnel (F) avec une plaque indicatrice (S) pour un automate programmable industriel (ST), où l'automate (ST) possède un châssis (T) pour la fixation des groupes fonctionnels (F), où les boîtiers respectifs (G1,G2*) possèdent à une face latérale deux éléments de guidage parallèles ( FE11, FE21 respectivement FE12, FE22), lesquels enveloppent partiellement la plaque indicatrice (S) et possèdent une butée (AT) pour limiter la course de la plaque indicatrice mobile (S).

2. Groupe fonctionnel selon la revendication 1, **caractérisé en ce que** le boîtier (G1, G2*) est composé de deux pièces, **en ce que** dans la première pièce de boîtier (G1) les éléments de guidage (FE11, FE2) sont installés à l'intérieur et **en ce que** la deuxième pièce de boîtier (G2*) à deux éléments de guidage correspondants (FE12, FE22) à l'extérieur ou une fente frontale (SC).

3. Groupe fonctionnel selon la revendication 1, **caractérisé en ce que** la plaque indicatrice (S) est lamelliforme avec un cavalier (R) et possède une encoche (AS).

4. Groupe fonctionnel selon la revendication 2, **caractérisé en ce que** la butée (AT) pour là limitation de la course est située au coté intérieur et au bord de la première pièce de boîtier (G1) et la butée (AT) à une forme de clavette.

5. Groupe fonctionnel selon une ou plusieurs revendications 1 à 4, **caractérisé en ce que** le boîtier (G2*) à au front une plaque protectrice transparente (AP), dont le coté longitudinal est parallèle et proche de la plaque indicatrice (S).

6. Groupe fonctionnel selon une ou plusieurs revendications 1 à 5, **caractérisé en ce que** la deuxième pièce de boîtier (G2*) à au coté frontal une encoche (N) pour le placement d'une étiquette (BS).

7. Groupe fonctionnel selon la revendication 2, **caractérisé en ce que** la paroi de la deuxième pièce de boîtier (G2*) est encochée entre les deux éléments de guidage et **en ce que** les éléments de guidage (FE12, FE22) ont une forme de languette.
